# EUROPEAN PATENT APPLICATION

(11) **EP 4 498 783 A1**
(43) Date of publication of application: **29.01.2025**
(21) Application number: 24190479.6
(22) Date of filing: 23.07.2024
(51) Int. Cl.: H10K 85/50, H01L 31/0216, H01L 31/054, H10K 30/40, H10K 30/50, H10K 30/80, H10K 30/87

(54) **CONCENTRATION-TYPE PEROVSKITE SOLAR ASSEMBLY**

(30) Priority: 27.07.2023 CN 202310936209
(71) Applicant: Huaneng Renewables Corporation Limited, Beijing 100036 (CN); Huaneng Clean Energy Research Institute, Beijing 102209 (CN)
(72) Inventor: ZHOU, Yangying, Beijing 102209 (CN); XIAO, Ping, Beijing 102209 (CN); ZHAO, Zhiguo, Beijing 102209 (CN); QIN, Xiaojun, Beijing 102209 (CN); ZHAO, Dongming, Beijing 102209 (CN); LIN, Zizhen, Beijing 102209 (CN); WANG, Xingtao, Beijing 102209 (CN)
(74) Representative: Albert Catala, Andrea

(57) **Abstract**

The disclosure provides a concentration-type perovskite solar assembly, which includes a micro-concentrating layer, an antireflection layer, a perovskite assembly and a top layer being sequentially arranged; the micro-concentrating layer includes multiple micro-concentrating units; the plurality of micro-concentrating units are sequentially arranged in rows. According to the disclosure, through the micro-concentrating layer and the antireflection layer, additional large-region condensers can be avoided, and the cost is effectively reduced; the perovskite solar assembly can operate under the condition of low light concentration, and the device efficiency is improved.

## Description

### TECHNICAL FIELD

The disclosure relates to the technical field of perovskite solar cells, and in particular relates to a concentration-type perovskite solar assembly.

### BACKGROUND

With the rapid improvement of the efficiency of perovskite solar cells, it has gradually become the most potential industrialization technology in the photovoltaic industry in the future. However, at present, the efficiency of perovskite cell is close to 80% of its S-Q limit, so it is difficult to further improve it. Stacking and concentrating are commonly used means to break through the S-Q limit of photovoltaic cells. Perovskite-based stacked solar cells have been studied a lot, but concentration-type perovskite cells still have great room for development.

At present, for concentration-type perovskite cells, Fresnel lens is mainly used as the condenser, and the device structure is complex, the cost is high, and it is not suitable for large-region perovskite cells.

### SUMMARY

In view of this, it is an object of the disclosure to provide a concentration-type perovskite solar assembly, which can effectively improve the incident light intensity in the active region of the perovskite assembly and control the weak light region in the inactive region of the perovskite assembly, effectively simplify the cell structure and reduce the cost; and efficiency is high.

The disclosure provides a concentration-type perovskite solar assembly, which includes a micro-concentrating layer, an antireflection layer, a perovskite assembly and a top layer being sequentially arranged;
the micro-concentrating layer includes multiple micro-concentrating units;
the plurality of micro-concentrating units are sequentially arranged in rows.

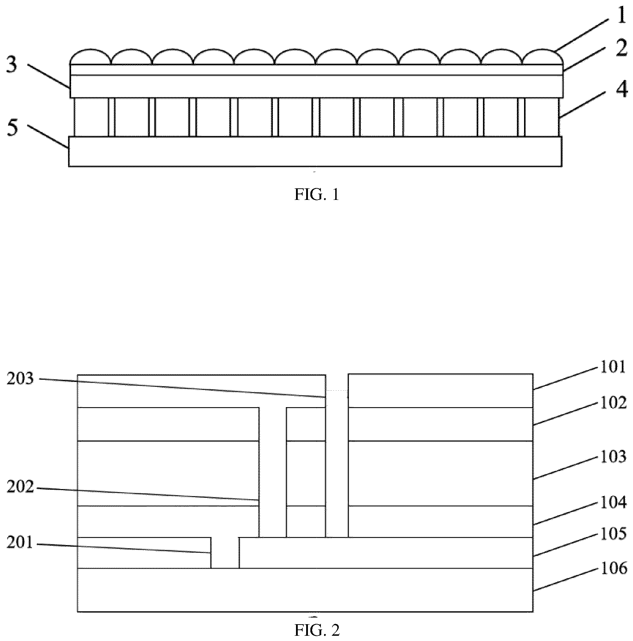

Refer to FIG. 1, where 1 represents a micro-concentrating layer, 2 represents an antireflection layer, 3 and 4 constitute a perovskite assembly, and 5 represents a top layer.

In this disclosure, a surface, away from the antireflection layer, of each of the micro-concentrating units is in a shape of an arc projection;
a central angle formed by two arc ends of the arc projection and a circle center of the arc projection is 120 - 150 degrees; the chord width is 2 - 10mm. Multiple micro-concentrating units form a micro-concentrating array, and each micro-concentrating unit adopts an arc lens made of optical glass, which is mainly used for concentrating the incident sunlight, improving the incident light intensity, and adjusting the concentration range and focusing degree by adjusting the arc radian and chord width of a single arc.

In this disclosure, a thickness of the antireflection layer is 30 -130 nm;
a thickness of the micro-concentrating layer is 0.5 -3 mm.

In this disclosure, a material of the antireflection layer is selected from Si₃N₄, MgFx, Ti₃N₄ and SiO₂. The antireflection layer can effectively reduce the reflectivity of sunlight and improve the transmittance and the uniformity of light distribution. The antireflection layer can adopt a commercial anti-reflection film, and it can be directly pasted under the micro-concentrating layer to make it flat and evenly attached to the substrate 106 in the perovskite assembly. The antireflection layer can also be prepared by itself, and can be prepared on the substrate 106 by vapor deposition or magnetron sputtering.

In this disclosure, 3 and 4 constitute a perovskite assembly, 3 is bottom glass, which is used as a preparation substrate of assembly and plays a role in protection and support. The thickness of the bottom glass is 1 - 4 mm.

In this disclosure, the top layer is top glass, which mainly plays a role in protecting perovskite assembly, improving stability and providing support for the assembly; the thickness is 1 - 4 mm.

In this disclosure, the perovskite assembly includes an inactive region.

Projection is performed along a stacking direction of the concentration-type perovskite solar assembly, a connection region of adjacent micro-concentrating units is within a projection range of the inactive region in the perovskite assembly. The connection region of adjacent micro-concentrating units is a weak light region, and the disclosure controls it within the range of inactive region, so that optical loss can be avoided.

In this disclosure, a width of the inactive region is 0.5 - 2 mm;
a width of single subcell in the perovskite assembly is 4 - 10 mm.

Referring to FIG. 2, in the disclosure, the perovskite assembly includes a top electrode 101, an electron transport layer 102, a perovskite light absorption layer 103, a hole transport layer 104, a transparent electrode 105 and a substrate 106. Where, the substrate 106 is the component 3 in FIG. 1. Component 3 is bottom glass.

In this disclosure, the thickness of the top electrode is 50 - 90 nm; the thickness of the electron transport layer is 30 - 200nm, the thickness of the perovskite light absorption layer is 200 - 700 nm, the thickness of the hole transport layer is 20 -60 nm, the thickness of the transparent electrode is 80 - 300nm, and the thickness of the substrate is 1 - 4 mm.

The disclosure is suitable for different perovskite solar cell structures and has a wide application range. Take the p-i-n structure as an example, where 101 is a metal electrode, mainly Au, Ag, Cu, etc. 102 is the electron transport layer, which plays the role of electron transport and hole blocking, mainly C₆₀, PCBM, BCP, etc. 103 is a perovskite light absorption layer, and the chemical general formula of its material is ABX₃, where A is FA, MA, Cs, etc, B is Pb, Sn, etc, and X is I, Br, Cl, etc. 104 is the hole transport layer, mainly PTAA, P₃HT, NiOx, etc. 105 is a transparent conductive electrode, mainly ITO, FTO, AZO, etc. 106 is the bottom glass.

In this disclosure, the perovskite assembly includes an inactive region, that is, the laser scribing region, that is, it includes region 201, region 202 and region 203 in FIG. 2. The width of the inactive region is from the left side of the region 201 to the right side of the region 203.

The disclosure provides a concentration-type perovskite solar assembly, which includes a micro-concentrating layer, an antireflection layer, a perovskite assembly and a top layer being sequentially arranged; the micro-concentrating layer includes multiple micro-concentrating units; the plurality of micro-concentrating units are sequentially arranged in rows. According to the disclosure, through the micro-concentrating layer and the antireflection layer, additional large-region condensers can be avoided, and the cost is effectively reduced; the perovskite solar assembly can operate under the condition of low light concentration, and the device efficiency is improved.

### BRIEF DESCRIPTION OF THE DRAWINGS

FIG. 1 is a schematic structural diagram of a concentration-type perovskite solar assembly according to the disclosure; and
FIG. 2 is a schematic structural diagram of a perovskite assembly according to the disclosure.

### DETAILED DESCRIPTION OF THE EMBODIMENTS

In order to further illustrate the disclosure, a concentration-type perovskite solar assembly provided by the disclosure will be described in detail in combination with the embodiment below, but they cannot be understood as limiting the scope of protection of the disclosure.

### Preparation Example 1

Preparation of SiNx film by magnetron sputtering
Step 1: after the substrate (glass to be sputtered) is cleaned, ultraviolet pretreatment is performed for 10min to improve the surface state of the glass, and the source target is a silicon target;
step 2: the pressure of the vacuum chamber is pumped to 6×10⁻⁴Pa, and baking is started, the baking temperature is 200°C;
step 3: argon and nitrogen with a flow ratio of 1:1 are introduced, the vacuum chamber pressure is stabilized at 0.4Pa, the power of the silicon target is adjusted to 2kW, and the deposition time is 20 min;
step 4: the deposited silicon nitride film is annealed, the annealing temperature is 500°C and the time is 30min.

### Preparation Example 2: preparation of micro-concentrating Layer

The optical glass is mechanically processed to form an array of arc lenses arranged in rows in sequence as a micro-concentrating layer, and the surfaces of the arc lenses are arc-shaped protrusions, and the chord width corresponding to the arc-shaped protrusion is 8mm, and the central angle formed by the two arc ends of the arc-shaped protrusion and the circle center of the arc-shaped protrusion is 135 degrees.

### Comparative Example 1

Preparation method of perovskite assembly (bottom-up layer-by-layer preparation method is adopted):
step 1: ultrasonic cleaning is performed on ITO glass, and the cleaning sequence is cleaning agent, deionized water and ethanol, with a single-step cleaning time of 30min, and air drying is performed after cleaning.
Step 2: laser scribing inactive region 201 is performed on ITO glass, with laser wavelength of 1064 nm, line width of 20 microns and interval width of 6 mm.
Step 3: hole transport layer is prepared by magnetron sputtering NiOx, with vacuum degree of 5×10⁻⁴ Pa, oxygen flow rate of 40 sccm, argon flow rate of 30 sccm, deposition chamber pressure of 0.5Pa, sputtering power of 100 W and time of 10min. The annealing temperature after sputtering is 500°C and the time is 60min.
Step 4: perovskite film is prepared by slit coating. The concentration of perovskite solution is 1.4 mol/L, the height of coating cutter head is 100 microns, the moving speed is 10 mm/s, and the liquid outlet speed is 2 mL/min. After coating, the solvent is quickly volatilized by vacuum flash evaporation, and then it is taken out for annealing, the annealing temperature is 100°C and the time is 30min.
Step 5: C₆₀ and BCP electron transport layers are prepared by vapor deposition, the vacuum degree is 5×10⁻⁴Pa, and the vapor deposition time is about 30 min and 10 min, respectively, and a film thickness meter is used to observe to reach the specified thickness (30 nm and 10 nm).
Step 6: laser scribing the inactive region 202 is performed on the device obtained in step 5, with the laser wavelength of 1064 nm, the width of 202 inactive region being 20 microns, and the 202 region being parallel to the 201 region.
Step 7: the Au electrode is prepared by vapor deposition, the vacuum degree is 2×10⁻⁴Pa, and the vapor deposition time is about 40 min, and a film thickness meter is used to observe to reach the specified thickness (70 nm).
Step 8: the device obtained in step 7 is laser scribed inactive region 203, the laser wavelength is 1064 nm, the line width is 20 microns, and the 203 region is parallel to the 202 region.
Step 9 (optional): laser edge cleaning is performed on the device obtained in step 8, with the laser wavelength of 1064 nm, and the perovskite film with many edge defects is removed.
Step 10: the prepared perovskite assembly is covered with commercial POE adhesive film on the Au electrode, and then the edge is pasted with butyl protective adhesive, then covered with optical glass, and then put it into a laminator with hot pressing pressure of 0.2 MPa, temperature of 90°C and time of 10min.

### Example 1

Steps 1 to 10 are the same as in Comparative Example 1;
step 11: the back bottom glass of the prepared perovskite assembly is scrubbed with ethanol, drying is performed with nitrogen, and then a sticker-type commercial multilayer Si₃N₄/SiO₂ antireflection film is sticked;
step 12: the micro-concentrating layer in Preparation Example 2 is attached, and the edge is attached and fixed with optical adhesive;
projection is performed along the stacking direction of concentration-type perovskite solar assembly, a connection region of adjacent micro-concentrating units is within a projection range of the inactive region in the perovskite assembly.

### Example 2

Step 1: the commercial ITO glass is ultrasonically cleaned, and the cleaning sequence is cleaning agent, deionized water and ethanol, with a single-step cleaning time of 30 min, followed by air drying. Si₃N₄ films are prepared by magnetron sputtering with the ITO-free surface of glass as the surface to be sputtered by the method provided in Preparation Example 1. The sputtered Si₃N₄ film is covered with polymer plastic film as protection to prevent it from being damaged in the subsequent preparation process.

steps 2 to 10 are the same as in Comparative Example 1;
step 11: the plastic protective film on the side of Si₃N₄ antireflection film is removed, and a nitrogen gun is used for purging and cleaning;
step 12: the micro-concentrating layer in Preparation Example 2 is attached, and the edge is bonded and fixed with optical adhesive.

### Comparative Example 2

Compared with Example 1, no antireflection film is introduced.

### Performance test:

### 1) Optical performance

For the linear micro-concentrating array with chord width of 8mm prepared in Preparation Example 2, that is, the micro-concentrating layer, the light intensity below the micro-concentrating array is measured with a light intensity meter under a standard solar light intensity.

In the central region of the array (3-5 mm), the average light intensity is 1.3 standard solar light intensities; in the lateral regions (1-3 mm,5-7 mm), the average light intensity is 1.1 standard solar light intensity; in the edge region (0-1 mm, 7-8 mm), the average light intensity is 0.8 standard solar light intensity.

### 2) Photoelectric performance

According to the disclosure, the photoelectric performance parameters of large-region perovskite assembly (the number of series-connected subcells is 10) prepared in Comparative Examples 1-2 and

### Example 1 are as follows:

**Table 1 Test results of photoelectric performance of assemblies prepared by comparative examples and examples**

| sample | open-circuit voltage Voc/V | short-circuit current density Jsc/mA • cm⁻² | fill factor FF/ % | efficiency Eff/ % |
|---|---|---|---|---|
| Comparative Example 1 | 11.04 | 18.32 | 70.56 | 14.27 |
| Example 1 | 11.57 | 21.81 | 72.71 | 18.34 |
| Example 2 | 11.61 | 21.64 | 73.05 | 18.35 |
| Comparative Example 1 | 11.55 | 20.75 | 72.74 | 17.43 |

Compared with Example 1, in Comparative Example 2, the short-circuit current of the assembly will decrease without introducing antireflection film, so the introduction of antireflection film has a good effect on enhancing the light absorption capacity of the assembly and improving the short-circuit current.

Comparative Example 1 compared with Example 1, the open-circuit voltage and short-circuit current density of perovskite photovoltaic assembly are significantly improved after the antireflection film and micro-concentrating array are introduced, which shows that antireflection film and micro-concentrating array can effectively concentrate the active region of perovskite photovoltaic assembly. Compared with ordinary assembly under outdoor actual lighting conditions, it can greatly improve the conversion efficiency and power of assembly without significantly increasing the cost and working temperature.

As can be seen from the above embodiments, the disclosure provides a concentration-type perovskite solar assembly, which includes a micro-concentrating layer, an antireflection layer, a perovskite assembly and a top layer being sequentially arranged; the micro-concentrating layer includes multiple micro-concentrating units; the plurality of micro-concentrating units are sequentially arranged in rows. According to the disclosure, through the micro-concentrating layer and the antireflection layer, additional large-region condensers can be avoided, and the cost is effectively reduced; the perovskite solar assembly can operate under the condition of low light concentration, and the device efficiency is improved.

The above is only the preferred embodiment of the disclosure, and it should be pointed out that those skilled in the art can make several improvements and embellishments without departing from the principle of the disclosure, and these improvements and embellishments should also be regarded as the protection scope of the disclosure.

## Claims

1. A concentration-type perovskite solar assembly, comprising a micro-concentrating layer, an antireflection layer, a perovskite assembly and a top layer being sequentially arranged: wherein the micro-concentrating layer comprises a plurality of micro-concentrating units; the plurality of micro-concentrating units are sequentially arranged in rows.

2. The concentration-type perovskite solar assembly according to claim 1, wherein a surface, away from the antireflection layer, of each of the micro-concentrating units is in a shape of an arc projection; a central angle formed by two arc ends of the arc projection and a circle center of the arc projection is 120 - 150 degrees.

3. The concentration-type perovskite solar assembly according to claim 1, wherein a thickness of the antireflection layer is 30 -130 nm; a thickness of the micro-concentrating layer is 0.5 -3 mm.

4. The concentration-type perovskite solar assembly according to claim 1, wherein a material of the antireflection layer is selected from Si₃N₄, Ti₃N₄ and Si0₂.

5. The concentration-type perovskite solar assembly according to claim 1, wherein the perovskite assembly comprises an inactive region; projection is performed along a stacking direction of the concentration-type perovskite solar assembly, a connection region of adjacent micro-concentrating units is within a projection range of the inactive region in the perovskite assembly.

6. The concentration-type perovskite solar assembly according to claim 5, wherein a width of the inactive region is 0.5 - 2 mm; a width of single subcell in the perovskite assembly is 4 - 10 mm.
